# EUROPÄISCHE PATENTANMELDUNG

(11) **EP 1 621 892 A1**
(43) Veröffentlichungstag der Anmeldung: **01.02.2006**
(21) Anmeldenummer: 05106844.3
(22) Anmeldetag: 26.07.2005
(51) Int. Cl.: G01R 1/20

(54) **Vorrichtung zum Messen eines elektrischen Stroms**

(30) Priorität: 30.07.2004 DE 102004037194
(71) Anmelder: Hella KGaA Hueck & Co., 59552 Lippstadt (DE)
(72) Erfinder: Scheibe, Winfried, 59557 Lippstadt (DE); Schöllmann, Matthias, 33098 Paderborn (DE); Lütkenhaus, Kay, 48317 Drensteinfurt (DE)

(57) **Zusammenfassung**

Vorrichtung zum Messen eines elektrischen Stroms
- mit einem Nebenwiderstand umfassend ein Widerstandselement (1) und zwei elektrisch dem Widerstandselement vorbeziehungsweise nachgeschaltete Anschlusselemente (2,3);
- mit einer Schaltungsanordnung zum Erfassen des durch den Nebenwiderstand fließenden Strom umfassend einen Schaltungsträger (4) und zumindest ein Bauelement (5), insbesondere ein aktives Bauelement;
wobei
- der Nebenwiderstand beabstandet von dem Schaltungsträger (4) angeordnet ist und dass die Vorrichtung Verbindungselemente umfasst, über welche die Schaltungsanordnung mit dem Nebenwiderstand elektrisch verbunden ist.

## Beschreibung

### STAND DER TECHNIK

Die Erfindung betrifft eine Vorrichtung zum Messen eines elektrischen Stroms, insbesondere in einem Kraftfahrzeugbordnetz. Die Vorrichtung weist einen Nebenwiderstand auf, der ein Widerstandselement und zwei dem Widerstandselement elektrisch vor- beziehungsweise nachgeschaltete Anschlusselemente aufweist, über welche der Nebenwiderstand in einen elektrischen Stromkreis eingesetzt werden kann. Die Vorrichtung umfasst ferner eine Schaltungsanordnung zum Erfassen des durch den Nebenwiderstand durchfließenden Stroms, der einen Schaltungsträger und zumindest ein Bauelement, vorteilhaft ein aktives Bauelement aufweist.

Eine derartige Vorrichtung ist aus der Druckschrift mit der Veröffentlichungsnummer EP 1 030 185 B1 bekannt. Der Nebenwiderstand bei der in dieser Druckschrift offenbarten Vorrichtung ist insgesamt plattenförmig ausgebildet. Der Schaltungsträger der Schaltungsanordnung ist über Lötverbindungen unmittelbar mit den Anschlusselementen des Nebenwiderstands verbunden. Die Schaltungsanordnung hat dadurch eine elektrisch leitende Verbindung mit dem Nebenwiderstand und eine Erfassung des durch den Nebenwiderstand fließenden Stroms ist dadurch möglich. Die unmittelbare Verbindung der Schaltungsanordnung mit dem Nebenwiderstand hat jedoch den Nachteil, dass die Schaltungsanordnung und der Nebenwiderstand nicht nur elektrisch, sondern auch thermisch sehr stark miteinander gekoppelt sind. Die in dem Nebenwiderstand entstehende Wärme kann ohne weiteres in die Schaltungsanordnung abgeführt werden, welches zu einer erhöhten Wärmeüberlastung der Bauelemente der Schaltungsanordnung führt. Dieses kann einen zusätzlichen Aufwand für die Kühlung der Bauelemente der Schaltungsanordnung nach sich ziehen. Eine gleichwertige Schaltungsanordnung ist im übrigen aus der Druckschrift mit der Veröffentlichungsnummer US 6,304,062 B1 bekannt.

### VORTEILE DER ERFINDUNG

Vor dem Hintergrund der Nachteile des Standes der Technik liegt der Erfindung die Aufgabe zugrunde, eine Vorrichtung zum Messen eines elektrischen Stroms der eingangs genannten Art so weiterzubilden, so dass zum einen die elektrische Funktion der Vorrichtung gesichert ist und zum anderen der Nebenwiderstand und die Schaltungsanordnung zum Erfassen des durch den Nebenwiderstand fließenden Stroms möglichst thermisch voneinander entkoppelt sind.

Diese Aufgabe wird durch eine erfindungsgemäße Vorrichtung nach Anspruch 1 gelöst. Demnach wird eine Vorrichtung der eingangs genannten Art so weitergebildet, dass der Nebenwiderstand beabstandet von dem Schaltungsträger angeordnet ist und die Vorrichtung Verbindungselemente umfasst, über welche die Schaltungsanordnung mit dem Nebenwiderstand elektrisch verbunden ist. Durch den Abstand zwischen dem Schaltungsträger und dem Nebenwiderstand wird der Wärmeeintrag des Nebenwiderstands in die Schaltungsanordnung erheblich gemindert. Die Verbindungselemente, die vorzugsweise so ausgelegt sind, dass sie nur geringe Wärmemengen übertragen können, sichern zugleich die elektrische Verbindung zwischen der Schaltungsanordnung und dem Nebenwiderstand. Zu den Verbindungselementen im Sinne der Erfindung zählen einfache Lötverbindungen, wie sie aus den genannten Druckschriften bekannt sind, nicht.

Das Widerstandselement des Nebenwiderstands kann vorteilhaft rotationssymmetrisch ausgebildet sein. Ebenso ist es möglich, dass das Widerstandselement aus Manganin besteht oder Manganin umfasst. Die Anschlusselemente des Nebenwiderstands sind vorteilhaft aus Kupfer hergestellt. Auch die Anschlusselemente können rotationssymmetrisch ausgebildet sein. Vorteilhaft sind sie koaxial zu dem Widerstandselement angeordnet. Ferner können sie den gleichen Durchmesser wie das Widerstandselement haben. Der Nebenwiderstand mit den Anschlusselementen und dem Widerstandselement kann so im Wesentlichen zylindrisch ausgebildet sein.

Bei den Verbindungselementen, welche die elektrische Verbindung zwischen dem Nebenwiderstand und der elektrischen Schaltungsanordnung herstellen, kann es sich um Bonddrähte handeln. Diese Bonddrähte können unmittelbar mit den Bauelementen der Schaltungsanordnung verbunden sein.

Bei den Verbindungselementen kann es sich ebenso um Anschlussfahnen beziehungsweise Federelemente handeln. Die Anschlussfahnen und die Federelemente können an dem Schaltungsträger zum Beispiel durch Einpressen befestigt sein. Diese Verbindungselemente können dann über Leiterbahnen mit den Bauelementen der elektrischen Schaltungsanordnung verbunden sein. Die Federelemente können den Nebenwiderstand sowohl elektrisch als auch mechanisch mit dem Schaltungsträger der Schaltungsanordnung verbinden.

Die Verbindungselemente einer erfindungsgemäßen Vorrichtung können unmittelbar mit dem Widerstandselement oder aber unmittelbar mit den Anschlusselementen des Nebenwiderstands verbunden sein.

Eine vorteilhafte Vorrichtung hat einen Ausgang, an dem ein Signal anliegt, welches den von der Vorrichtung gemessenen Strom durch den Nebenwiderstand darstellt. Dieses Signal kann vorteilhaft von der Schaltungsanordnung, insbesondere von einem aktiven Bauelement der Schaltungsanordnung erzeugt werden.

Der Ausgang kann durch ein Steckverbinderelement gebildet werden. Dieses Steckverbinderelement kann zumindest teilweise durch ein Gehäuse gebildet werden, welches den Nebenwiderstand, die Verbindungselemente und die Schaltungsanordnung einhäust. Die Schaltungsanordnung, der Nebenwiderstand und die Verbindungselemente können im übrigen vergossen sein.

Die Verbindungselemente können im übrigen durch Schweißen oder Löten oder auf andere Art und Weise stoffschlüssig mit dem Nebenwiderstand verbunden sein.

### ZEICHNUNGEN

Zwei Ausführungsbeispiele für erfindungsgemäße Vorrichtungen zum Messen eines elektrischen Stroms sind anhand der Zeichnung näher beschrieben. Darin zeigt
- Fig. 1: eine perspektivische Darstellung des ersten Ausführungsbeispiels,
- Fig. 2: eine Seitenansicht des ersten Ausführungsbeispiels,
- Fig. 3: eine Draufsicht auf das erste Ausführungsbeispiel,
- Fig. 4: eine Frontansicht des ersten Ausführungsbeispiels,
- Fig. 5: eine perspektivische Darstellung des zweiten Ausführungsbeispiels,
- Fig. 6: eine Seitenansicht des zweiten Ausführungsbeispiels und
- Fig. 7: eine Draufsicht auf das zweite Ausführungsbeispiel.

### BESCHREIBUNG DER AUSFÜHRUNGSBEISPIELE

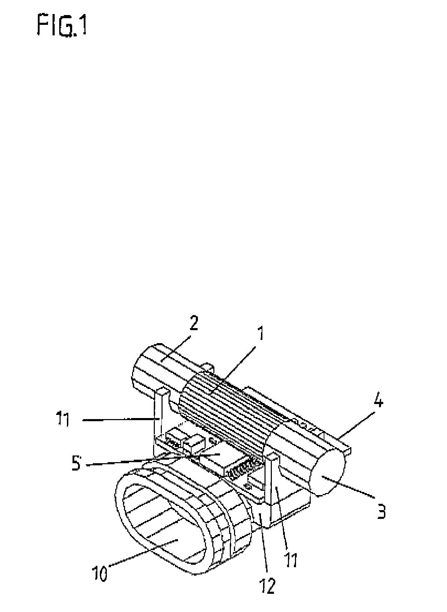

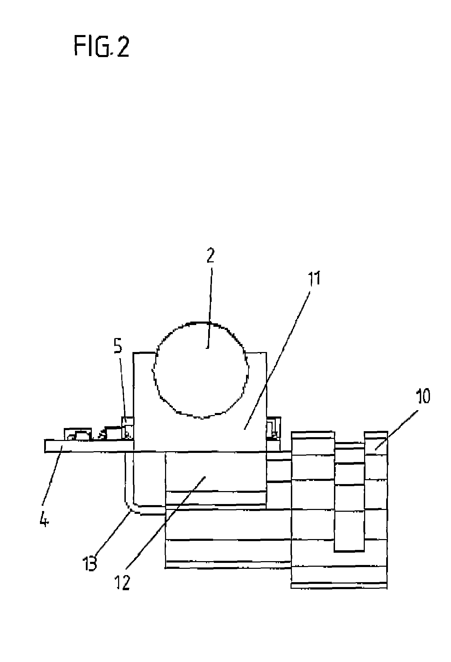

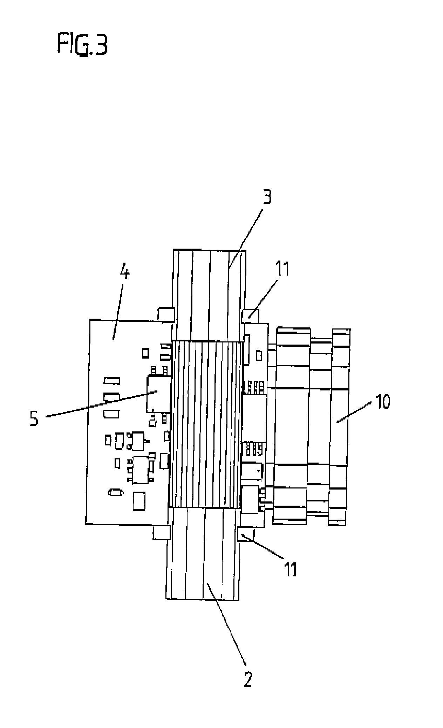

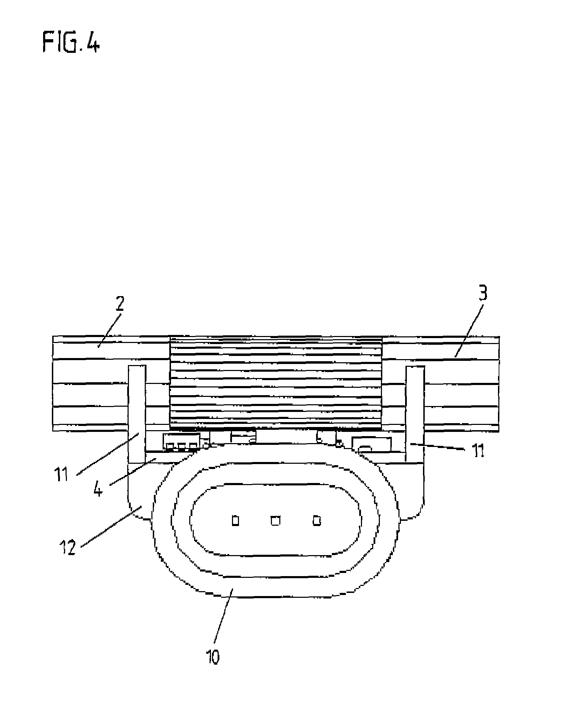

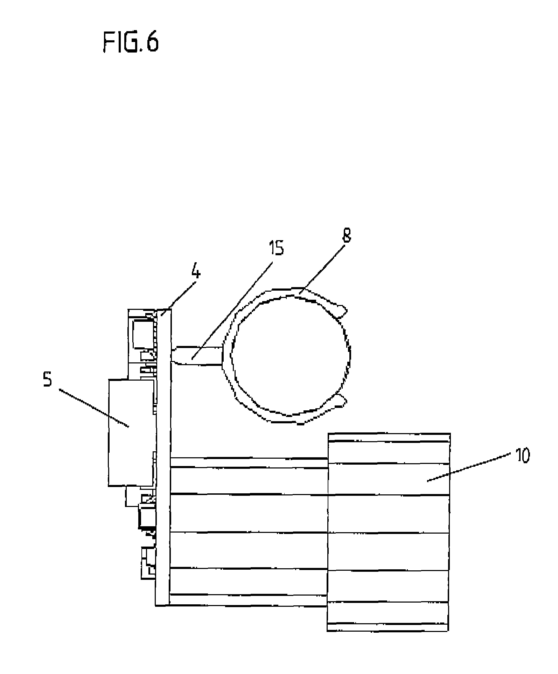

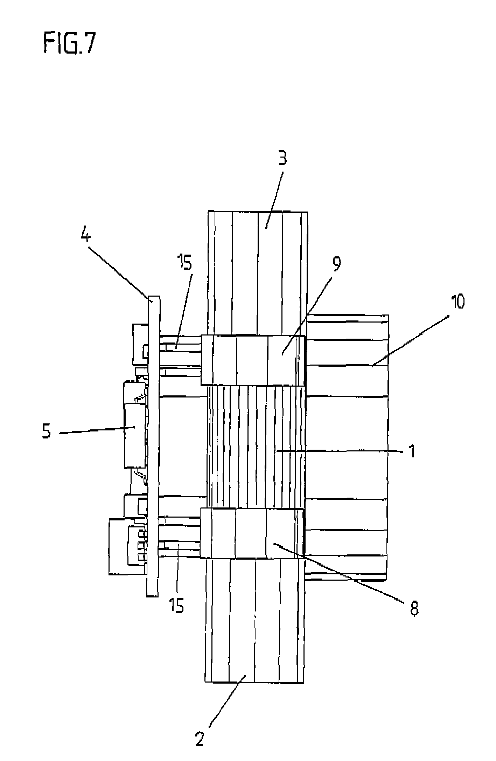

Die in den Fig. 1 bis 7 dargestellten Ausführungsbeispiele erfindungsgemäßer Vorrichtungen zum Messen eines elektrischen Stroms weisen zum Teil gleiche oder gleichartige Bauteile auf. Die gleichen und gleichartigen Bauteile der verschiedenen Ausführungsbeispiele sind in den Zeichnungen mit gleichen Bezugszeichen gekennzeichnet.

Das in den Fig. 1 bis 4 dargstellte Ausführungsbeispiel für eine erfindungsgemäße Vorrichtung zum Messen eines elektrischen Stroms weist einen rotationssymmetrischen, d. h. im Wesentlichen zylindrischen Nebenwiderstand 1, 2, 3 auf, der ein zylindrisches Widerstandselement 1 und zwei stirnseitig daran angeschlossene, ebenfalls zylindrische Anschlusselemente 2, 3 umfasst. Über die Anschlusselemente 2, 3 kann der Nebenwiderstand 1, 2, 3 in einen elektrischen Stromkreis eingeschaltet werden. Der dann durch den Nebenwiderstand 1, 2, 3 fließende Strom soll von der erfindungsgemäßen Vorrichtung gemessen werden.

Die erfindungsgemäße Vorrichtung weist ein aus Kunststoff hergestelltes Brückenteil 12 auf, an dem voneinander beabstandet Stege 11 angebracht sind. Die Stege 11 und das Brückenelement 12 können einstückig als Spritzgussteil hergestellt sein. Die dem Brückenelement 12 abgewandten Enden der Stege 11 weisen Kehlen auf, in welche der Nebenwiderstand 1, 2, 3 mit den Anschlusselementen 2, 3 eingelegt ist. Durch Kleben oder Ähnliches ist der Nebenwiderstand 1, 2, 3 mit den Stegen 11 verbunden. Somit ist eine mechanische Verbindung zwischen dem Nebenwiderstand 1, 2, 3 und dem Brückenelement 12 unter Zwischenschaltung der Stege 11 hergestellt.

An dem Brückenelement 12 ist zwischen den Stegen 11 und unterhalb des Nebenwiderstands 1, 2, 3 jedoch mit Abstand zu diesem Nebenwiderstand 1, 2, 3 eine Schaltungsanordnung 4, 5 angebracht. Diese Schaltungsanordnung wird durch einen Schaltungsträger 4 und einer Vielzahl von Bauelementen, darunter ein aktives Bauelement 5, bei dem es sich um einen Mikroprozessor handelt, gebildet, die auf dem Schaltungsträger 4 angeordnet sind. Diese Schaltungsanordnung 4, 5 ist über Verbindungselemente 6, 7, bei dem es sich im ersten Ausführungsbeispiel um Bonddrähte handelt, mit dem Nebenwiderstand 1, 2, 3 verbunden *(Herr Lütkenhaus, bitte tragen Sie die Bonddrähte in den beigefügten Skizzen ein. Wir werden dann die Zeichnung entsprechend vervollständigen.)*

An dem Brückenelement 12 ist ein Steckverbinderelement 10 angeformt. In dieses Steckverbinderelement 10 sind Kontaktstifte 13 eingesetzt. Diese Kontaktstifte 13 ragen in die Buchse des Steckverbinderelements 10 hinein und dienen der elektrischen Kontaktierung der erfindungsgemäßen Vorrichtung anderen Einrichtungen, so dass diese anderen Einrichtungen Informationen über den gemessenen Strom abgreifen können. Die Kontaktstifte 13 sind rückseitig aus dem Steckverbinderelement 10 herausgeführt, um 90° abgewinkelt und zum Schaltungsträger 4 geführt. Mit ihren schaltungsträgerseitigen Enden sind die Kontaktstifte 13 in dem Schaltungsträger 4 eingepresst und elektrisch mit der Schaltungsanordnung 4, 5 verbunden.

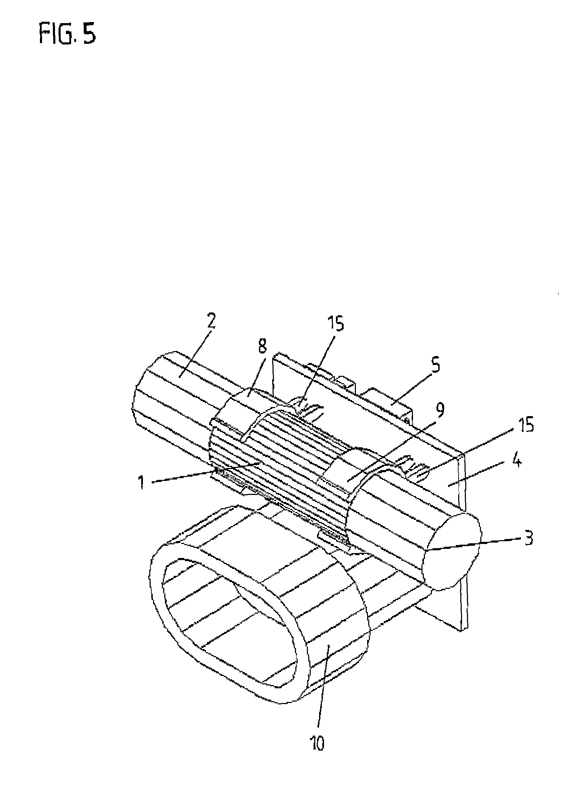

Das in den Fig. 5 bis 7 dargestellte zweite Ausführungsbeispiel für eine erfindungsgemäße Vorrichtung zum Messen eines elektrischen Stroms weist einen Nebenwiderstand 1, 2, 3 auf, der genauso ausgebildet ist wie der Nebenwiderstand des ersten Ausführungsbeispiels. Im Unterschied zu dem ersten Ausführungsbeispiel ist der Nebenwiderstand 1, 2, 3 des zweiten Ausführungsbeispiels jedoch sowohl elektrisch leitend als auch mechanisch über Verbindungselemente 8, 9 unmittelbar mit einem Schaltungsträger 4 verbunden. Der Schaltungsträger 4 ist Teil einer Schaltungsanordnung 4, 5 zum Erfassen des durch den Nebenwiderstand 1, 2, 3 fließenden Stroms. Die Schaltungsanordnung umfasst den Schaltungsträger 4 und Bauelemente, darunter ein aktives Bauelement 5. Die Bauelemente sind auf einer dem Nebenwiderstand abgewandten Seite des Schaltungsträgers 4 angebracht. Der Schaltungsträger 4 ermöglicht dadurch eine thermische Abschirmung der Bauelemente gegenüber dem Nebenwiderstand 1, 2, 3. Als Verbindungselemente 8, 9 sind Federelemente vorgesehen, die über Kontaktstifte 15 mit dem Schaltungsträger verbunden sind. Die Kontaktstifte 15 sind dazu in dem Schaltungsträger 4 eingepresst. Die Federelemente 8, 9 haben jeweils zwei Federarme, die bogenförmig ausgebildet sind und federnd vorbelastet an dem Nebenwiderstand 1, 2, 3 anliegen. Dadurch ist sowohl eine mechanische als auch eine elektrische Verbindung zwischen den Federelementen und dem Nebenwiderstand 1, 2, 3 hergestellt.

An dem Schaltungsträger 4 des zweiten erfindungsgemäßen Ausführungsbeispiels ist ferner noch ein Steckverbinderelement 10 angebracht. Dieses Steckverbinderelement 10 weist nicht dargestellte Kontaktstifte auf, die rückseitig des Steckverbinderelements mit der Schaltungsanordnung elektrisch verbunden sind, so dass über das Steckverbinderelement 10 die von der Schaltungsanordnung 4, 5 ausgewerteten Informationen über den elektrischen Strom durch den Nebenwiderstand 1, 2, 3 abgreifbar sind.

Der Vorteil der beiden erfindungsgemäßen Ausführungsbeispiele ist, dass keine unmittelbare Verbindung zwischen der Schaltungsanordnung 4, 5 und dem Nebenwiderstand 1, 2, 3 besteht. Zwar sind die Schaltungsanordnung 4, 5 und der Nebenwiderstand 1, 2, 3 sowohl mechanisch als auch elektrisch verbunden, diese elektrische sowie mechanische Verbindung ist jedoch so ausgestaltet, dass ein Wärmetransport vom Nebenwiderstand 1, 2, 3 in die Schaltungsanordnung 4, 5 möglichst minimiert ist. Dieser erfindungsgemäße Zweck wird durch die Zwischenschaltung der Verbindungselemente 6, 7, beziehungsweise 7, 9 erreicht. Durch die Verbindungselemente 6, 7, beziehungsweise 8, 9 ist es möglich, die Schaltungsanordnung beabstandet zu dem Nebenwiderstand 1, 2, 3 anzuordnen.

## Patentansprüche

1. Vorrichtung zum Messen eines elektrischen Stroms
- mit einem Nebenwiderstand umfassend ein Widerstandselement (1) und zwei elektrisch dem Widerstandselement vorbeziehungsweise nachgeschaltete Anschlusselemente (2, 3);
- mit einer Schaltungsanordnung zum Erfassen des durch den Nebenwiderstand fließenden Strom umfassend einen Schaltungsträger (4) und zumindest ein Bauelement (5), insbesondere ein aktives Bauelement;
**dadurch gekennzeichnet,**
- **dass** der Nebenwiderstand beabstandet von dem Schaltungsträger (4) angeordnet ist und dass die Vorrichtung Verbindungselemente (6, 7, 8, 9) umfasst, über welche die Schaltungsanordnung mit dem Nebenwiderstand elektrisch verbunden ist.

2. Vorrichtung nach Anspruch 1, **dadurch gekennzeichnet, dass** die Verbindungselemente Bonddrähte (6, 7) sind.

3. Vorrichtung nach Anspruch 2, **dadurch gekennzeichnet, dass** die Bonddrähte (6, 7) unmittelbar mit den Bauelementen (5) der Schaltungsanordnung verbunden sind.

4. Vorrichtung nach Anspruch 1, **dadurch gekennzeichnet, dass** die Verbindungselemente Anschlussfahnen sind.

5. Vorrichtung nach Anspruch 1, **dadurch gekennzeichnet, dass** die Verbindungselemente Federelemente (8, 9) sind.

6. Vorrichtung nach Anspruch 4 oder 5, **dadurch gekennzeichnet, dass** die Verbindungselemente (8, 9) an dem Schaltungsträger (4) zum Beispiel durch Einpressen befestigt sind.

7. Vorrichtung nach Anspruch 6, **dadurch gekennzeichnet, dass** die Verbindungselemente (8, 9) über Leiterbahnen mit den Bauelementen (5) verbunden sind.

8. Vorrichtung nach einem der Ansprüche 1 bis 7, **dadurch gekennzeichnet, dass** die Verbindungselemente (6, 7, 8, 9) unmittelbar mit dem Widerstandselement (1) verbunden sind.

9. Vorrichtung nach einem der Ansprüche 1 bis 7, **dadurch gekennzeichnet, dass** die Verbindungselemente (6, 7, 8, 9) unmittelbar mit den Anschlusselementen (2, 3) verbunden sind.

10. Vorrichtung nach einem der Ansprüche 1 bis 9, **dadurch gekennzeichnet, dass** die Vorrichtung einen Ausgang (10) hat, an dem ein den von der Vorrichtung gemessener Strom darstellendes Signal anliegt, das von der Schaltungsanordnung erzeugbar ist.
